(19) Europäisches Patentamt
European Patent Office
Office européen des brevets

(11) Veröffentlichungsnummer: **0 164 059**
**A2**

(12) **EUROPÄISCHE PATENTANMELDUNG**

(21) Anmeldenummer: **85106566.4**

(22) Anmeldetag: **29.05.85**

(51) Int. Cl.⁴: **C 08 G 8/32**, G 03 C 1/52, B 41 M 1/08

(30) Priorität: **08.06.84 DE 3421448**

(43) Veröffentlichungstag der Anmeldung: **11.12.85**
**Patentblatt 85/50**

(84) Benannte Vertragsstaaten: **CH DE FR GB LI**

(71) Anmelder: **HOECHST AKTIENGESELLSCHAFT, Postfach 80 03 20, D-6230 Frankfurt am Main 80 (DE)**

(72) Erfinder: **Müller, Werner H., Dr. Dipl.-Chem., 22 Coveside Ct., East Greenwich, R.I. 02818 (US)**

(54) **Perfluoralkylgruppen aufweisende Polymere, sie enthaltende Reproduktionsschichten und deren Verwendung für den wasserlosen Offsetdruck.**

(57) Die neuen Perfluoralkylgruppen aufweisenden Polymeren sind Polymerisate oder Polykondensate und weisen – jeweils als Substituenten an unterschiedlichen C-Atomen von Benzolringen – phenolische OH-Gruppen und gegebenenfalls über Zwischenglieder gebundene Perfluoralkylgruppen auf, wobei insbesondere mindestens 10% der Polymerbausteine Perfluoralkylgruppen tragen. Diese Polymeren werden entweder durch Kondensation von substituierten Phenolen (z.B. 4-Hydroxybenzoesäure-perfluoralkylester) mit einem Aldehyd, Keton oder einer reaktiven Bismethylenverbindung oder durch Umsetzung von phenolische OH-Gruppen aufweisenden Polymerisaten (z.B. Hydroxypolystyrol) oder Polykondensaten (z.B. Phenol-Formaldehyd-Harze) mit einer Perfluoralkylgruppen aufweisenden Verbindung (z.B. 2,2-Dihydroperfluordecansäurechlorid) hergestellt.

Die neuen Polymeren werden insbesondere in strahlungsempfindlichen Reproduktionsschichten eingesetzt, die daneben noch mindestens eine strahlungsempfindliche Verbindung enthalten. Solche Reproduktionsschichten finden als strahlungsempfindliche Beschichtung von Druckplattenträgermaterialien für den wasserlosen Offsetdruck Verwendung.

Ein Beispiel für ein erfindungsgemässes Polymeres ist das folgende mit einem Verhältnis der Bausteine von etwa 2:1 (Anzahl der linken Bausteine zu den rechtsstehenden):

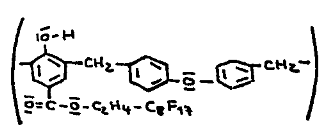 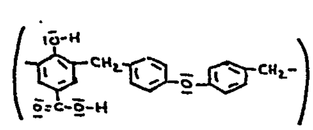

EP 0 164 059 A2

H O E C H S T   A K T I E N G E S E L L S C H A F T
KALLE Niederlassung der Hoechst AG

84/K050

28. Mai 1985
WLK-Dr.N.-ur

# Perfluoralkylgruppen aufweisende Polymere, sie enthaltende Reproduktionsschichten und deren Verwendung für den wasserlosen Offsetdruck

Die Erfindung betrifft Perfluoralkylgruppen aufweisende Polymere und ein Verfahren zu deren Herstellung; außerdem betrifft sie strahlungsempfindliche Reproduktionsschichten, die diese Polymere als Bindemittel enthalten, und deren Verwendung für den wasserlosen Offsetdruck.

Beim wasserlosen Flachdruck, insbesondere Offsetdruck wird - im Unterschied zum üblicherweise eingesetzten Offsetdruck - beim Drucken die Differenzierung in Bild- und Nichtbildstellen nicht durch das gleichzeitige Einwirken von Wasser oder wasserhaltigen Flüssigkeiten einerseits und Druckfarbe andererseits bewirkt, sondern die Differenzierung erfolgt in der Regel durch eine unterschiedliche Wechselwirkung zwischen farbannehmenden bzw. oleophilen und (nicht-wasserfeuchten) farbabweisenden bzw. oleophoben Stellen auf einer Druckplattenoberfläche mit der Druckfarbe. Aus dem Stand der Technik sind dazu beispielsweise die folgenden Druckschriften bekannt:

In der DE-C 15 71 890 (= US-A 3 677 178) wird eine Druckplatte beschrieben, die auf einem Trägermaterial aus einem Metall, einem Kunststoff oder Papier eine Schicht aus einem hydrophoben und oleophoben Silikonkautschuk und

eine strahlungsempfindliche Reproduktionsschicht in dieser oder der umgekehrten Reihenfolge aufweist. Die Reproduktionsschicht enthält als strahlungsempfindliche Verbindung Ammoniumdichromat, Formaldehydkondensate von Diphenylamin-4-diazoniumsalzen oder Polyvinylcinnamat. Die beim Drucken farbführenden Stellen sind entweder freigelegte Teile des Trägermaterials oder durch das Bestrahlen gehärtete Teile der Reproduktionsschicht.

Die Druckplatte gemäß der DE-B 16 71 637 (= US-A 3 511 178 und 3 682 633) weist auf einem Trägermaterial zunächst eine strahlungsempfindliche Reproduktionsschicht und darauf eine Beschichtung auf, die gegenüber Druckfarben einen geringeren Ablösewert (geringere adhäsive Wechselwirkung) als das Trägermaterial hat. Die letztgenannte Beschichtung besteht entweder aus einem Polysiloxan (Silikonelastomer) oder einer fluorhaltigen organischen Verbindung wie einem Homopolymer aus dem Methacrylsäureester des Perfluoroctanols.

Weitere Ausgestaltungen von Druckplatten für den wasserlosen Offsetdruck bzw. von dafür geeigneten Verbindungen sind beispielsweise den folgenden Druckschriften zu entnehmen:

Aus der DE-A 23 54 838 (= US-A 3 953 212) ist die Kombination einer strahlungsempfindlichen Verbindung mit einem Silikonkautschuk in einer Schicht auf einem der üblichen Trägermaterialien bekannt. Die Druckplatte gemäß der DE-B 24 22 428 (= GB-A 1 464 123) enthält in einer Schicht ein

HOECHST AKTIENGESELLSCHAFT
KALLE Niederlassung der Hoechst AG



photopolymerisierbares Polysiloxan und einen Photosensibilisator.

In der DE-A 25 24 562 (= GB-A 1 501 128) werden strahlungsempfindliche Beschichtungen beschrieben, die ein aromatisches Diazoniumkation, ein Anion einer Perfluoralkylgruppen aufweisenden Carbon- oder Sulfonsäure und gegebenenfalls ein polymeres organisches Bindemittel enthalten. Von dieser Schicht soll nach dem Bestrahlen direkt, d. h. ohne Entwicklungsschritt, gedruckt werden können.

In einer oleophoben Beschichtung enthalten die Druckplatten nach der DE-A 26 48 278 (= US-A 4 087 584) ein fluorhaltiges Homo- oder Copolymerisat mit Monomereneinheiten, die sich von Acrylsäure- oder Methacrylsäureestern mit Perfluoralkyl-, 4-Perfluoralkoxy-benzoyloxy-alkyl- oder Perfluoralkan-sulfonamido-alkyl-Gruppen ableiten. Bei Copolymerisaten ist der Anteil der fluorhaltigen Monomereneinheiten größer als 75 %. Diese oleophobe Beschichtung befindet sich entweder direkt auf einem Trägermaterial und Bildbezirke werden auf die Beschichtung aufgetragen oder sie befindet sich oberhalb einer elektrophotographisch-arbeitenden Reproduktionsschicht, so daß dann auf der oleophoben Beschichtung Tonerbilder erzeugt werden.

Aus der US-A 3 910 187 sind verschiedene Möglichkeiten bekannt, aus üblichen Photopolymerdruckplatten (d. h. Druckplatten aus einem Trägermaterial und einer Reproduktionsschicht mit einem Gehalt an photopolymerisierbaren

---

Verbindungen) durch Aufbringen einer Zwischen- oder Abschlußschicht Druckplatten für die Anwendung im wasserlosen Offsetdruck zu erzeugen. Diese Zwischen- oder Abschlußschichten enthalten entweder Perfluoralkylgruppen aufweisende Carbon-, Sulfon-, Phosphonsäuren und Amine oder Polymerisate aus Perfluoralkylgruppen aufweisenden Acrylsäure- oder Methacrylsäureestern, Maleinsäurediestern, Vinylethern, Carbonsäurevinylestern, Sulfonamidoallylestern u. ä.; die Polymerisate werden entweder bereits vor dem Aufbringen auf die Druckplatte aus den genannten Monomeren oder direkt auf den Druckplatten durch Photopolymerisation hergestellt.

Der EP-A 0 037 094 ist zu entnehmen, daß strahlungsempfindliche Polymere (u.a. für den Einsatz als Beschichtung für Druckplatten) hergestellt werden können, die Copolymerisate aus a) Acrylsäure- oder Methacrylsäure-perfluoralkylestern und b) Acrylsäure- oder Methacrylsäure-azidobenzoyloxy-alkylestern sind. Strahlungsempfindliche Reproduktionsschichten können neben diesen Copolymerisaten auch noch alkalisch-entwickelbare organische Bindemittel und übliche Hilfsmittel enthalten. Nach der Bestrahlung und Entwicklung wird auf dem Trägermaterial ein Reliefbild erzeugt. In der EP-A 0 040 841 werden strahlungsempfindliche Polymere beschrieben, die Copolymerisate aus a) Monomeren mit endständigen Perfluoralkylgruppen und endständigen ethylenisch-ungesättigten Gruppen und b) Monomeren mit strahlungsempfindlichen Gruppen und ethylenisch-ungesättigten Gruppen sind. Zu der ersten Gruppe von Monomeren zählen beispielsweise Acrylsäure-

HOECHST AKTIENGESELLSCHAFT
KALLE Niederlassung der Hoechst AG



oder Methacrylsäure-perfluoralkylester und zu der zweiten Gruppe beispielsweise Methacrylsäure-azidobenzoyloxyalkylester, Acrylsäure-cinnamoyloxy-alkylester, Methacrylsäure-benzoyl-phenylester oder Methacrylsäure-cinnamoyl-phenylester. Aus der EP-A 0 096 845 sind strahlungsempfindliche Polymere bekannt, die Copolymerisate aus a) Acrylsäure- oder Methacrylsäure-2-perfluoralkoxy-2-fluor-ethyl-1-estern oder verwandten Verbindungen, b) Monomeren mit strahlungsempfindlichen Gruppen und ethylenisch-ungesättigten Gruppen und c) gegebenenfalls weiteren fluorfreien copolymerisierbaren Vinylmonomeren sind.

Bei den bisher für die Herstellung von Druckformen für den wasserlosen Offsetdruck bekanntgewordenen Reproduktionsschichten müssen häufig organische Lösemittel wie 2-Butoxyethanol-(1), Ethylenglykol-monoethylether, Methylenchlorid, Dioxan oder Hexafluor-m-Xylol im Entwicklungsschritt eingesetzt werden, so daß aufwendige Redestillationsanlagen u. ä. für eine umweltfreundliche Aufarbeitung erforderlich sind. Außerdem sind die Ausgangskomponenten oftmals nur schwer (d. h. zum Beispiel über mehrere Stufen) zu synthetisieren, so daß sie für eine großtechnische Anwendung nicht oder nur in untergeordnetem Maße in Betracht gezogen werden können. Mit Reproduktionsschichten, die kein Bindemittel enthalten und/oder nach deren Bestrahlung kein zusätzlich differenzierender Entwicklungsschritt durchgeführt wird, sind im allgemeinen keine höheren Druckauflagen zu erzielen. Bindemittel enthaltende Reproduktionsschichten, die als

strahlungsempfindliche Komponente bereits eine fluoralkylgruppenhaltige Verbindung aufweisen, sind nicht ohne weiteres herzustellen, da die üblichen Bindemittel häufig nicht oder nur erschwert mit diesen Verbindungen zu einer homogen-wirkenden Beschichtung vereinigt werden können. Oftmals treten die Auswirkungen der möglichen Unverträglichkeit der beiden Hauptkomponenten von Reproduktionsschichten, nämlich der strahlungsempfindlichen Komponente und der Bindemittelkomponente, nicht bereits beim Herstellen der Beschichtungsmasse, sondern erst bei bzw. nach ihrer Trocknung, d. h. der Entfernung des Löse- bzw. Dispergiermittels auf.

Aufgabe der vorliegenden Erfindung ist es deshalb, neue Fluoralkylgruppen enthaltende Polymere, insbesondere für den Einsatz auf dem Gebiet des wasserlosen Offsetdrucks, zu synthetisieren, die eine gute Verträglichkeit mit anderen Komponenten aufweisen, möglichst aus im Handel erhältlichen Ausgangsstoffen (Edukten) hergestellt und in Reproduktionsschichten nach der Bestrahlung möglichst mit wäßrigen Lösungen (insbesondere mit wäßrig-alkalischen Lösungen) entwickelt werden können.

Gegenstand der Erfindung sind Perfluoralkylgruppen enthaltende Polymere, die dadurch gekennzeichnet sind, daß sie - jeweils als Substituenten an unterschiedlichen C-Atomen von Benzolringen - phenolische OH-Gruppen und gegebenenfalls über Zwischenglieder gebundene Perfluoralkylgruppen aufweisen. Insbesondere können die Polymeren durch folgende allgemeine Formeln beschrieben werden:

(I)

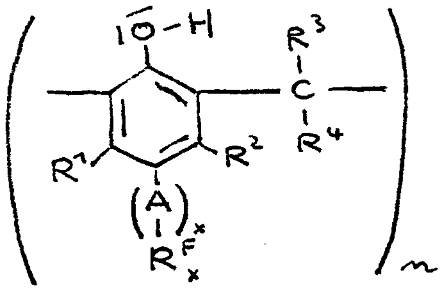

(II)

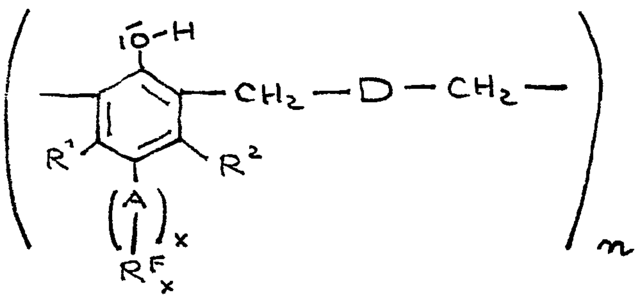

(III)

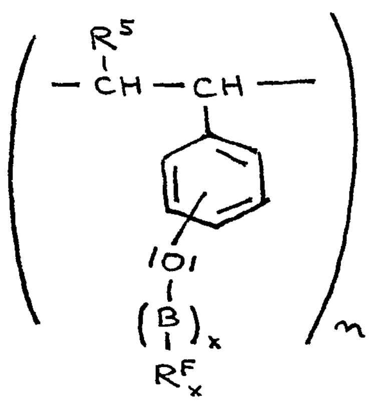

(IV)

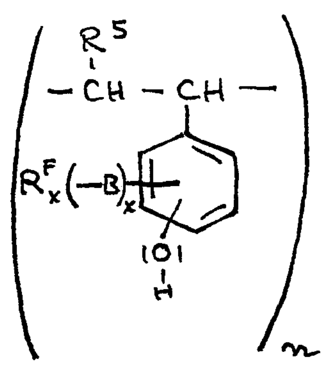

(V)

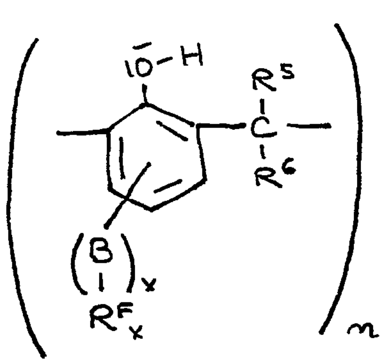

(VI)

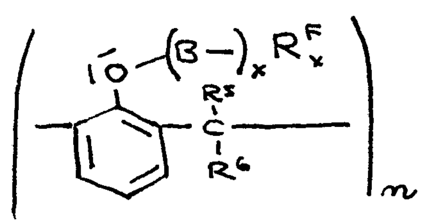

In diesen allgemeinen Formeln (I) bis (VI) bedeuten: $R^1$, $R^2$ = H, Alkyl von $C_1$ bis $C_6$, $R^F$, $\overline{O}-H$, $\overline{O}-$Alkyl ($C_1$ bis $C_6$), $\overset{|O|}{\overset{\|}{C}}-R^F$; $R^F = F(C_wF_{2w})(-CH_2)_z$ oder $F(C_{w-1}F_{2w-2})-CF=CH$, wobei die Difluormethylengruppen gegebenenfalls auch über Etherbrücken verknüpft sein können; w = 5 bis 15; z = 0 bis 5; x = 0 oder 1; $R^3$, $R^4$ = Alkyl von $C_1$ bis $C_6$, H, Phenyl, $R^F$; n = 5 bis 10 000; A = $\overset{|O|}{\overset{\|}{C}}-\underline{\overline{O}}$, $R^F$, $\overset{|O|}{\overset{\|}{C}}-R^F$, $\overset{|O|}{\overset{\|}{C}}-\underline{\overline{O}}-H$; D = Alkylen von $C_1$ bis $C_8$, Phenylen, Naphthylen, Biphenylen (auch mit Ether-, Thioether- oder Carbonylgruppen überbrückt); $R^5$, $R^6$ = H, Alkyl von $C_1$ bis $C_6$, Phenyl, Naphthyl; B = $\overset{|O|}{\overset{\|}{C}}$,

$\overset{|O|}{\overset{\|}{C}}-(CH_2)_z-\underline{\overline{O}}$, $\overset{R^7}{\overset{|}{CH}}-\underline{\overline{O}}$ ($R^7$ = Alkyl von $C_1$ bis $C_{12}$),

$\overset{|O|}{\overset{\|}{C}}-(CH_2)_z-\overset{|O|}{\overset{\|}{C}}-\underline{\overline{O}}$, $SO_2$, $SO_2-C_6H_4-$; wenn in $(B-)_xR^F{}_x$ beide Indices 0 sind, tritt an die Stelle des Substituenten ein H.

Der Benzolring in den Formeln (III) und (IV) kann darüber hinaus noch solche Substituenten tragen wie sie in Phenolharzen üblich sind, dies sind beispielsweise Alkylgruppen von $C_1$ bis $C_6$, Halogene wie Cl oder Br oder Alkoxygruppen von $C_1$ bis $C_4$. Die Polymeren der allgemeinen Formeln (I) und (II) sind so aufgebaut, daß mindestens 10 % und maximal 100 % der Polymerbausteine (Polymereinheiten) Perfluoralkylgruppen tragen, insbesondere 30 bis 100 %. Die Polymeren der allgemeinen Formeln (III) bis

(VI) sind so aufgebaut, daß mindestens 10 % und maximal 90 % der Polymerbausteine Perfluoralkylgruppen tragen, insbesondere 15 bis 60 %. Die Steuerung des Anteils an Perfluoralkylgruppen kann einerseits - insbesondere bei den Polymeren der allgemeinen Formeln (I) und (II) - über die Auswahl an Substituenten erfolgen, andererseits aber auch über das Verfahren zur Herstellung der Polymeren; diese letzte Variante kommt insbesondere bei dem nachträglichen Einführen von Perfluoralkylgruppen in bereits vorliegende Polymere in Betracht [allgemeine Formeln (III) bis (VI)], wobei dann in den Polymeren, die als Bausteine Einheiten entsprechend den allgemeinen Formeln (III) und (VI) aufweisen, anstelle der Substituenten $-\underline{\overline{O}}-(B-)_x R^F{}_x$ dann auch unsubstituierte $-\underline{\overline{O}}-$H-Gruppen stehen können bzw. in den Polymeren, die als Bausteine Einheiten entsprechend den allgemeinen Formeln (IV) und (V) aufweisen, anstelle der Substituenten $-(B-)_x R^F{}_x$ ein H, so daß in den erfindungsgemäßen Polymeren verschiedene Bausteine auftreten können.

Von den genannten Verbindungen sind die Verbindungen der allgemeinen Formeln (I), (II), (V) und (VI) Cokondensate und die der allgemeinen Formeln (III) und (IV) Copolymerisate. Die Perfluoralkylgruppe ist direkt oder über ein unverzweigtes oder verzweigtes, gesättigtes oder ungesättigtes Alkylenzwischenglied mit 1 bis 5 C-Atomen mit dem jeweiligen Molekülrest verbunden. Die Perfluoralkylgruppen selbst sind ungesättigt oder gesättigt, verzweigt oder unverzweigt und weisen im allgemeinen 4 bis 20 C-Atome, insbesondere 5 bis 15 C-Atome, auf; sie sind be-

HOECHST AKTIENGESELLSCHAFT
KALLE Niederlassung der Hoechst AG



vorzugt unverzweigte Molekülreste und haben maximal zwei Doppelbindungen pro Molekülrest. Die Molekularmassen der erfindungsgemäßen Polymeren liegen bei etwa 1 000 bis 100 000, insbesondere 1 200 bis 50 000.

Die erfindungsgemäßen Polymeren können wie folgt hergestellt werden. Die Verbindungen der allgemeinen Formeln (I) und (II) durch Kondensation einer phenolischen Komponente (VII) mit einem Aldehyd oder Keton der allgemeinen Formel (VIII) oder einer reaktiven Bismethylenverbindung der allgemeinen Formel (IX)

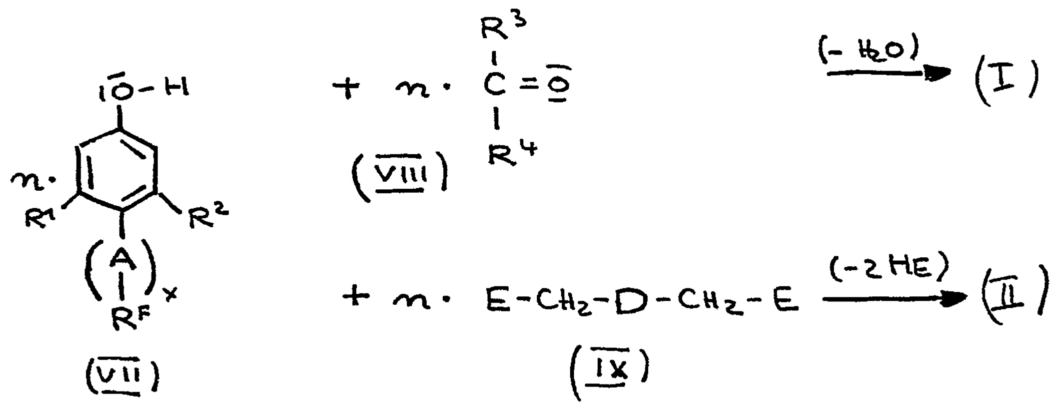

(VII) (VIII) (IX) (I) (II)

worin E = $\overline{O}$-H, $\overline{O}$-Alkyl($C_1$ bis $C_4$), Cl oder Br bedeutet. Ein Teil der Verbindungen der allgemeinen Formel (VII) kann auch durch Verbindungen ersetzt werden, in denen der Substituent $-(A-)_xR^F{}_x$ durch eine Carboxylgruppe

|O|
-C-$\underline{O}$-H ersetzt ist; jedoch sollten mindestens 10 % dieser Edukte einen Perfluoralkylrest tragen, insbesondere mindestens 30 % [entweder als Rest $R^1$ oder $R^2$ oder im Substituenten $-(A-)_xR^F{}_x$].

H O E C H S T   A K T I E N G E S E L L S C H A F T
KALLE Niederlassung der Hoechst AG



Die Verbindungen der allgemeinen Formeln (III) bis (VI) lassen sich aus den Polymerisaten (X) oder den Polykondensaten (XI) durch Umsetzung mit Perfluoralkylgruppen aufweisenden Carbonsäuren, Carbonsäurehalogeniden, Carbonsäureestern, Halogeniden, Alkoholen, Sulfonsäuren oder Sulfonsäurehalogeniden der allgemeinen Formel (XII) herstellen:

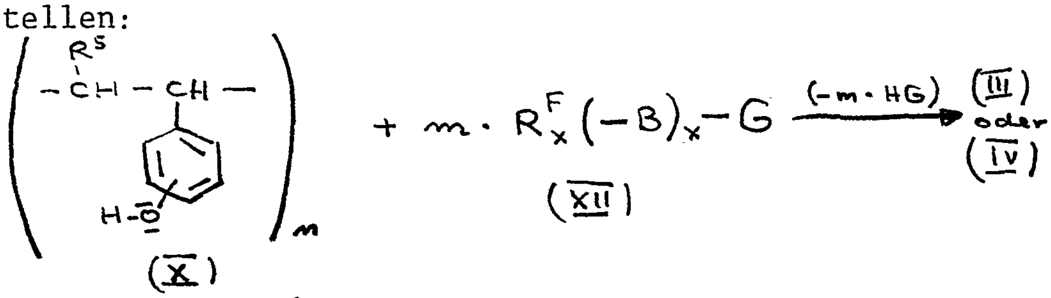

(X) (XII) (III) oder (IV)

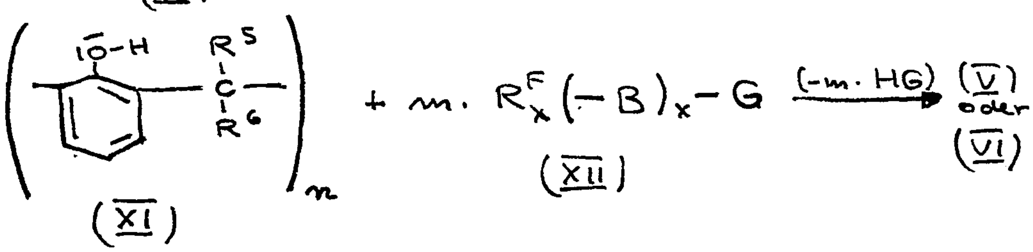

(XI) (XII) (V) oder (VI)

wobei G = $\overline{O}$-H, Hal (Br, Cl), $\overline{O}$-Alkyl($C_1$ bis $C_6$), bedeutet und m kleiner als n ist und mindestens 10 %, maximal jedoch 90 %, von n beträgt.

Beispiele für Verbindungen der allgemeinen Formel (VII) sind: Ester aromatischer Hydroxycarbonsäuren mit Perfluoralkylgruppen aufweisenden Alkoholen wie Ester der 4-Hydroxybenzoesäure, 2,6-Dialkyl-4-hydroxybenzoesäure, Salicylsäure, α- und β-Resorcylsäure, Gallussäure, β-Hydroxynaphthoesäure; Umsetzungsprodukte aromatischer Hydroxyverbindungen mit Perfluoralkylgruppen enthaltenden reaktiven Verbindungen der nachstehenden Formel (XII) im

alkalischen (z. B. in Anwesenheit von Triethylamin) oder sauren Medium (z. B. in Anwesenheit von $AlCl_3$):

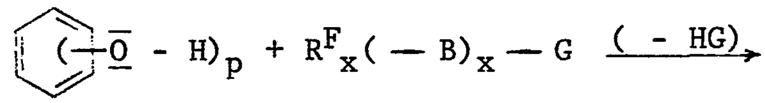


(XII)

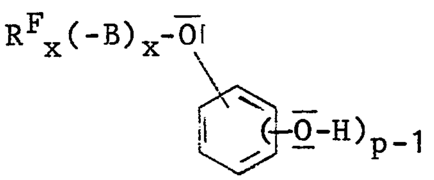

bzw.

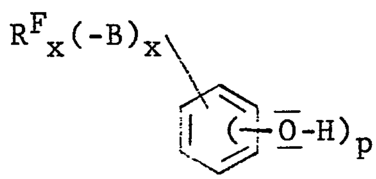

wobei p = 1 oder 2 bedeutet; und Umsetzungsprodukte von Phenol, Resorcin oder substituierten Resorcinen mit Perfluoralkylgruppen enthaltenden Säurechloriden, die entweder Phenolester oder Ketone sind.

Die vorstehend aufgeführten Verbindungen der allgemeinen Formel (VII) lassen sich in an sich bekannter Weise mit Aldehyden wie Formaldehyd, Acetaldehyd, Benzaldehyd oder Ketonen wie Aceton zu den Phenolharzen (I) und (II) kondensieren, die sehr gute hydrophobe und oleophobe Eigenschaften zeigen. Anstelle der Aldehyde oder Ketone können auch Verbindungen der allgemeinen Formel (IX) wie Bischlormethyl- oder Bishydroxymethyl-Verbindungen (z. B. Bismethoxymethyl-benzol, Bishydroxymethyl-benzol, Bischlormethyl-benzol, Bismethoxymethyl-diphenylether oder 2,6-Bismethoxymethyl-pyridin) eingesetzt werden. Die genannten Phenole können dabei allein oder auch im Gemisch mit anderen fluorhaltigen oder fluorfreien Phenolen umgesetzt werden, besonders vorteilhaft ist bei der letztgenannten Verfahrensweise die Cokondensation mit Carboxylgruppen aufweisenden Phenolen, da dadurch zusätzlich die Löslichkeit in wäßrig-alkalischen Lösungen gesteuert werden kann.

Beispiele für die Polymere der allgemeinen Formeln (X) und (XI) sind Hydroxypolystyrole (Polymerisate) der Bezeichnungen "(R)Resin M" der Firma Maruzen Oil Co. und Phenol-Formaldehyd-Harze (Polykondensate) der Bezeichnung "(R)Alnovol PN 429" der HOECHST AG, Frankfurt/Main-Höchst. Maximal 90 % der Hydroxylgruppen dieser Polymere werden mit reaktiven Perfluoralkylgruppen aufweisenden Verbindungen der allgemeinen Formel (XII) umgesetzt. Die Reaktion wird insbesondere entweder im alkalischen oder sauren Medium durchgeführt. Beispiele für geeignete Verbindungen der allgemeinen Formel (XII) sind 2,2-Dihydro-perfluordecansäurechlorid, Buten(2)-disäure-monochloridmono-1',1',2',2'-tetrahydro-perfluoroctyl-1'-ester, 3-Perfluoroctyl-benzolsulfonsäurechlorid oder 2-Chlorpropansäure-1',1',2',2'-tetrahydro-perfluoroctyl-1'-ester.

Die erfindungsgemäßen, Perfluoralkylgruppen enthaltenden Polymeren können zur Herstellung von hydrophoben und oleophoben Massen wie Lacken, Imprägnierungen oder Beschichtungen, insbesondere aber in strahlungsempfindlichen Reproduktionsschichten verwendet werden. Ein weiterer Gegenstand der Erfindung sind deshalb strahlungsempfindliche Reproduktionsschichten mit einem Gehalt an (c) mindestens einer strahlungsempfindlichen Verbindung

und (d) mindestens einem organischen polymeren Bindemittel, die dadurch gekennzeichnet sind, daß die Komponente (d) ein Polymeres aus den vorstehend definierten Komponenten ist. Insbesondere werden als Bindemittel solche Polymere eingesetzt, die in wäßrig-alkalischen Lösungen löslich sind. Bei dem Einsatz der erfindungsgemäßen Polymeren in Reproduktionsschichten als Komponente (d) werden als Komponente (c) insbesondere ebenfalls Fluor, bevorzugt Perfluoralkylgruppen enthaltende Verbindungen, gewählt, da dies häufig zu einer besseren Vermischbarkeit der Komponenten und damit zu einer auch optisch gleichmäßigeren Beschichtung führt. Neben den Polymeren gemäß der Erfindung können die Reproduktionsschichten auch noch von diesen verschiedene Bindemittel enthalten, die jedoch maximal 40 % des Bindemittelanteils ausmachen sollten.

Als Beispiele für geeignete Bindemittel seien genannt: Polyamide, Polyvinylester, Polyvinylacetale, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylmethylformamid, Polyvinylmethylacetamid sowie Mischpolymerisate der Monomeren, die die aufgezählten Homopolymerisate bilden. Ferner kommen als Bindemittel Naturstoffe oder umgewandelte Naturstoffe in Betracht, z. B. Gelatine oder Celluloseether.

Mit Vorteil werden Bindemittel verwendet, die in wäßrig-alkalischen Lösungen löslich oder mindestens quellbar

sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$, $-SO_2NH_2$, $-SO_2$-NH-CO-. Als Beispiele hierfür seien genannt: Maleinatharze, Polymerisate aus N-(p-Tolylsulfonyl)-carbaminsäure-(ß-methacryloyloxyethyl)-ester und Mischpolymerisate dieser und ähnlicher Monomeren mit anderen Monomeren, ferner Methylmethacrylat-Methacrylsäure-Copolymerisate oder Mischpolymerisate aus Methacrylsäure, Alkylmethacrylaten und Methylmethacrylat und/oder Styrol, Acrylnitril u.a.

In der Komponente (c), d. h. in der Komponente mit den strahlungsempfindlichen Verbindungen, können grundsätzlich alle Verbindungen eingesetzt werden, die in Reproduktionsschichten nach dem Bestrahlen (Belichten) mit einer nachfolgenden Entwicklung eine bildmäßige Fläche liefern, von der gedruckt werden kann.

Neben den auf vielen Gebieten verwendeten Silberhalogenide enthaltenden Schichten sind auch verschiedene andere bekannt, wie sie z. B. in "Light-Sensitive Systems" von Jaromir Kosar, John Wiley & Sons Verlag, New York 1965 beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schich-

H O E C H S T   A K T I E N G E S E L L S C H A F T
KALLE Niederlassung der Hoechst AG



ten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten.
Besonders bevorzugt sind als strahlungsempfindliche Verbindungen bzw. Systeme in der Komponente (c) der Reproduktionsschichten die in den gleichzeitig eingereichten Patentanmeldungen P 34 21 511.5 (interne Bezeichnung: Hoe 84/K048) und P 34 21 471.2 (interne Bezeichnung: Hoe 84/K051) mit den Titeln "Polymerisierbare, Perfluoralkylgruppen aufweisende Verbindungen, sie enthaltende Reproduktionsschichten und deren Verwendung für den wasserlosen Offsetdruck" und "Perfluoralkylgruppen aufweisende 1,2-Naphthochinondiazidverbindungen und Reproduktionsmaterialien, die diese Verbindungen enthalten" erstmalig beschriebenen Klassen von Verbindungen, nämlich ein System aus mindestens einer polymerisierbaren, Perfluoralkylgruppen aufweisenden Verbindung mit mindestens zwei endständigen ethylenisch-ungesättigten Gruppen, und mindestens einem Photoinitiator oder 1,2-Naphthochinondiazidverbindungen, die als Substituenten mindestens eine Perfluoralkylgruppe aufweisen.

Von der Komponente (c) enthalten die Reproduktionsschichten im allgemeinen 5 bis 50 %, im Falle des Einsatzes von photopolymerisierbaren Verbindungen bzw. Systemen auch bis zu 80 %, und von der Komponente (d) 95 bis 50 % [oder auch bis 20 % beim Einsatz von photopolymerisierbaren Verbindungen als Komponente (c)].

Die genannten Reproduktionsschichten können außer den Komponenten (c) und (d) noch eine Reihe weiterer üblicher Zusätze enthalten, z. B. Inhibitoren zur Verhinderung der thermischen Polymerisation von Monomeren, Wasserstoffdonatoren, sensitometrische Regler, Verlaufshilfsmittel, Indikatoren, Farbstoffe, Farbpigmente und ungefärbte Pigmente. Die Summe aller Komponenten soll 100 % ergeben. Diese Bestandteile sind zweckmäßig so auszuwählen, daß sie in dem für den Initiierungsvorgang wichtigen aktinischen Strahlungsbereich möglichst nicht zu stark absorbieren. Als aktinische Strahlung soll jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung. Die Herstellung der Reproduktionsschichten erfolgt in bekannter Weise. So kann man die Komponenten in einem Lösemittel aufnehmen und die Lösung bzw. Dispersion durch Gießen, Sprühen, Tauchen oder Antragen mit Walzen auf den vorgesehenen Träger als Film aufbringen und anschließend trocknen. Die Reproduktionsschichten werden in bekannter Weise belichtet und entwickelt. Als Entwickler sind wäßrige, vorzugsweise wäßrig-alkalische Lösungen, z. B. von Alkaliphosphaten oder Alkalisilikaten, geeignet, denen gegebenenfalls kleine Mengen an mischbaren organischen Lösemitteln und Netzmitteln zugesetzt werden können.

Die erfindungsgemäßen Polymeren führen insbesondere in Kombination mit den erwähnten Fluoralkylgruppen enthaltenden strahlungsempfindlichen Verbindungen bzw. Systemen zu homogen-aussehenden, gut-haftenden Reproduktionsschichten von hoher Strahlungsempfindlichkeit, die meistens in wäßrig-alkalischen Lösungen entwickelt werden können und ausgezeichnete Farbabstoßung bewirken. Es ist überraschend, daß die erfindungsgemäßen Polymeren auch bei einem Gehalt an fluorhaltigen Einheiten von 10 bis 20 % noch farbabstoßend sein können. Besonders überraschend ist es, daß die erfindungsgemäßen, phenolische OH-Gruppen enthaltenden Polymeren bei Einsatz als Bindemittel auch in Reproduktionsschichten von Photopolymerdruckplatten hoher Strahlungsempfindlichkeit eingesetzt werden können, obwohl man annimmt, daß an sich phenolische OH-Gruppen als Radikalfänger eher als Polymerisationsinhibitoren anzusehen sind.

Die erfindungsgemäßen Reproduktionsschichten eignen sich besonders in Form eines vorsensibilisierten Kopiermaterials auf einem geeigneten Träger, z. B. aus Aluminium, Polyester oder Zink, für die photomechanische Herstellung von Offsetdruckformen für den wasserlosen Offsetdruck. Das Trägermaterial aus z. B. Aluminium kann auch durch mechanische, chemische und/oder elektrochemische Aufrauhung und gegebenenfalls einer nachfolgenden anodischen Oxidation an der Oberfläche modifiziert werden.

Werden Trägermaterialien nur mit einem oder mehreren der Polymere und gegebenenfalls weiteren davon verschiedenen

Bindemitteln beschichtet, so zeigen auch diese Schichten bei guter mechanischer Stabilitat ausgezeichnete Wasser- und Farbabstoßung. Auch auf solchen beschichteten Materialien lassen sich - wie auch bereits aus dem Stand der Technik bekannt - durch mechanische, elektrische oder chemische Zerstörung von Teilen des Fluorpolymerfilms oder durch Betonerung oder Beschriftung Bildstellen erzeugen, die dann Farbe annehmen können, so daß auch von solchen modifizierten Materialien gegebenenfalls gedruckt werden kann.

In den nachfolgenden Beispielen und im vorstehenden Text verhalten sich Gew.-Teile zu Vol.-Teilen wie g zu $cm^3$ und %-Angaben sind - wenn nichts anderes angegeben ist - auf das Gewicht bezogen.

Beispiel 1 [Synthese einer Monomeren-Komponente der allgemeinen Formel (VII)]

Es werden 5 Gew.-Teile des 4-Hydroxybenzoesäuremethylesters (0,033 Mol) und 28 Gew.-Teile 1,1,2,2-Tetrahydroperfluordecanol (0,06 Mol) zusammen mit 2 Gew.-Teilen eines sauren Ionenaustauschers (z. B. (R)Amberlist 15) während 6 h auf 100 °C erhitzt. Das sich abscheidende Methanol wird über einen absteigenden Kühler aufgefangen. Danach wird der überschüssige Perfluoralkohol möglichst weitgehend abdestilliert und aus dem Rückstand durch wiederholte Kristallisation aus Essigsäureethylester der reine Perfluorester (4-Hydroxybenzoesäure-1',1',2',2'-tetrahydro-perfluordecylester) vom $F_p$ (Schmelzpunkt) 128 bis 129 °C gewonnen; $^1H$- und $^{19}F$-NMR-

Spektrum stimmen mit der angenommenen Struktur überein.

Beispiel 2

In Anlehnung an Beispiel 1 wird aus Gallussäure und dem Perfluoralkohol der entsprechende Gallussäureester erhalten, der nach Kristallisation aus einem Gemisch Essigsäureethylester/Diisopropylether einen $F_p$ von 170 bis 172 °C hat; die Spektren stimmen ebenfalls mit der angenommenen Struktur überein.

Beispiel 3 (Cokondensation)

Es wird nach den Angaben des Beispiels 1 der Perfluorester hergestellt, jedoch wird während 15 h auf 145 °C erhitzt und ohne Isolierung des Perfluoresters werden direkt 8 Gew.-Teile des 4,4'-Bis-methoxymethyl-diphenylethers (MMDPE) innerhalb von 1 h bei 145 °C zugetropft. Das Reaktionsgemisch wird dabei sehr viskos, bei der Entnahme einer Probe mit einem Glasstab lassen sich lange Fäden ziehen. Das Reaktionsgemisch wird auf etwa 50 bis 60 °C abgekühlt, mit Aceton verdünnt, vom Ionenaustauscher abfiltriert und unter gutem Rühren in Hexan gegossen. Nach mehrmaligem Waschen mit Hexan ergeben sich 15,7 Gew.-Teile eines pulvrigen Cokondensats, das keinen freien Perfluoralkohol enthält.

Beispiel 4 (Cokondensation)

Es wird zunächst nach den Angaben des Beispiels 1 der Perfluorester hergestellt, aber mit 15,2 Gew.-Teilen Ester (0,1 Mol), 46,4 Gew.-Teilen des Perfluoralkohols (0,1 Mol) und 6 Gew.-Teilen des Ionenaustauschers unter

HOECHST AKTIENGESELLSCHAFT
KALLE Niederlassung der Hoechst AG



Stickstoffüberlagerung bei 150 °C. Nach etwa 3 h ist die erwartete Menge an Methanol abgeschieden, so daß das Reaktionsgemisch auf 130 °C abgekühlt wird und 6,9 Gew.-Teile 4-Hydroxybenzoesäure in 40 Vol.-Teilen Dimethyl-diethylenglykol zugesetzt werden. Danach werden 38,9 Gew.-Teile MMDPE (0,15 Mol) gelöst in 30 Gew.-Teilen Dimethyl-diethylenglykol innerhalb von 4 h bei 130 °C zudosiert. Nach weiterem Rühren bei 130 °C wird abgekühlt, mit Aceton verdünnt und vom Ionenaustauscher abfiltriert. Die Acetonlösung wird langsam unter kräftigem Rühren in einen Überschuß an Wasser eingetropft, wobei sich das Cokondensat als faseriges, festes Produkt abscheidet; der Erweichungspunkt liegt bei 70 bis 90 °C, die Glastemperatur Tg (gemessen mit einem Differentialthermoanalysegerät) bei 14 °C. Das Cokondensat ist aus den folgenden Einheiten aufgebaut, wobei sich die Anzahl der linksstehenden Einheiten zu der der rechtsstehenden etwa wie 2 zu 1 verhält (der berechnete Fluorgehalt beträgt 32,5 %, der tatsächliche 32,8 %:

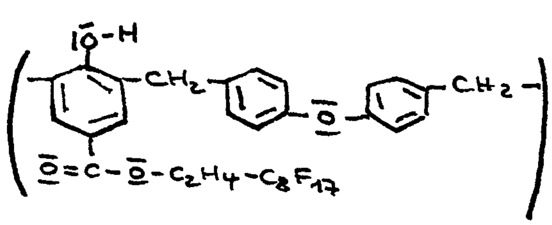 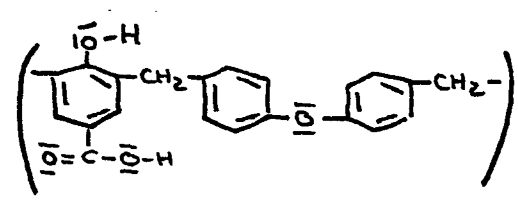

HOECHST AKTIENGESELLSCHAFT
KALLE Niederlassung der Hoechst AG



Beispiel 5 (Cokondensation)
In Anlehnung an Beispiel 4 wird aus 0,05 Mol 2,6-Dimethyl-4-hydroxybenzoesäuremethylester, 0,05 Mol des Perfluoralkohols, 0,025 Mol 4-Hydroxybenzoesäure und 0,075 Mol MMDPE ein weißes flockiges Pulver erhalten. Nach 12stündigem Trocknen im Umlufttrockenschrank hat das Cokondensat einen Erweichungspunkt von 90 bis 110 °C. Die Fluoranalyse zeigt aufgrund der sterischen Hinderung durch die benachbarten Methylgruppen, daß keine vollständige Umesterung stattgefunden hat (Theorie: 32,7 %, Analyse: 28,3 %). Eine auf eine aufgerauhte Aluminiumfolie aufgebrachte Beschichtung aus diesem Cokondensat (mit Butanon-2 und 1-Methoxy-propanol-2 als Lösemittel) zeigt eine ausgezeichnete Farbabstoßung.

Beispiele 6 bis 27 (Einführung eines Perfluoralkylesters in ein phenolische OH-Gruppen enthaltendes Polymeres)
Ein Formelgewicht des entsprechenden Phenolharzes wird in 1 000 Vol.-Teilen Aceton gelöst und die für die vollständige oder teilweise Umsetzung der phenolischen OH-Gruppen benötigte äquivalente Menge eines entsprechenden Perfluoralkylgruppen enthaltenden Säurechlorids zugegeben. Unter Eiskühlung wird die äquivalente Menge Triethylamin zugetropft, wobei die Temperatur unter 30 °C gehalten wird. Danach wird noch 2 h unter Rückfluß erhitzt. Nach dem Abkühlen wird vom unlöslichen Niederschlag abfiltriert, der Rückstand wird mit Wasser ausgewaschen und getrocknet (Fraktion 1). Das Filtrat wird in angesäuertes Eiswasser eingerührt, wobei ein heller Niederschlag ausfällt, der abfiltriert, neutral-gewaschen und im Umlufttrockenschrank bei 50 °C getrocknet wird (Fraktion 2). Die erste Fraktion enthält vermutlich höhermolekulare Polymere als Fraktion 2, für die Anwendungsbeispiele und die Analysen wird Fraktion 2 eingesetzt.

Beispiele 6 bis 18:

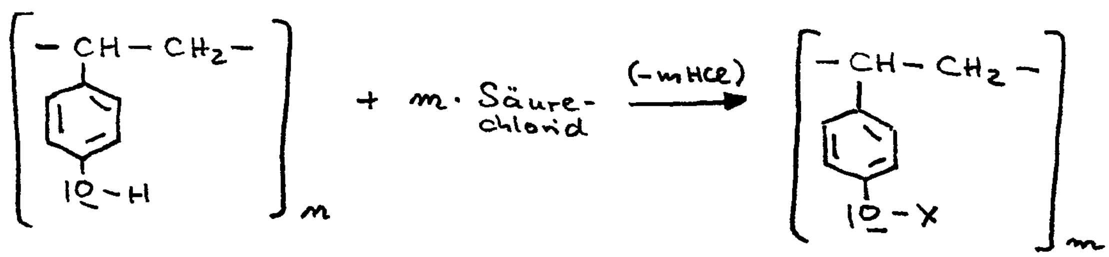


"(R)Resin M" der Maruzen Oil Comp.

x = Rest des Säurechlorids nach Cl-Abspaltung

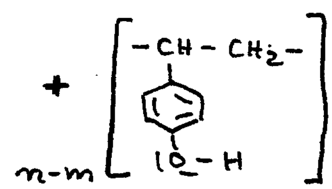

Tabelle I

| | Edukte | | | | Produkte | | | |
|---|---|---|---|---|---|---|---|---|
| Beispiel | Phenolharz | Gew.-Teile | Säurechlorid | Gew.-Teile | $F_1$ (Gew.-Teile) | $F_2$ (Gew.-Teile) | % F | Tm (°C) |
| 6 | RM 1 | 18 | $C_8F_{17}CH_2COCl$ | 22,4 | 9,7 | 24,3 | 46,6 | 150-170 |
| 7 | RM 1 | 24 | " | 22,4 | 11,9 | 28,7 | 38,6 | 150-180 |
| 8 | RM 1 | 36 | " | 22,4 | 10,8 | 40,5 | 27,7 | 190-210 |
| 9 | RM 2 | 18 | " | 22,4 | 13,7 | 21,5 | 43,3 | 130-150 |
| 10 | RM 2 | 24 | " | 22,4 | 14,9 | 25,1 | 42,6 | 150-170 |
| 11 | RM 2 | 36 | " | 22,4 | 15,2 | 40,6 | 29,6 | 190-210 |
| 12 | RM 1 | 18 | $C_{7,5}F_{16}CH_2OCO-CH=CH-CO-Cl$ | 30 | 17,6 | 24,1 | 39,5 | 160-180 |
| 13 | RM 1 | 24 | | 30 | 11,2 | 35,6 | 36,7 | 150-160 |
| 14 | RM 1 | 36 | | 30 | 8,0 | 52,4 | 28,6 | 180-200 |
| 15 | RM 2 | 18 | " | 30 | 17,4 | 22,3 | 40,4 | 160-180 |
| 16 | RM 2 | 24 | " | 30 | 22,0 | 25,6 | 37,8 | 160-180 |
| 17 | RM 2 | 36 | " | 30 | 11,6 | 51,8 | 29,2 | 170-190 |
| 18 | RM 1 | 36 | $C_7F_{15}COCl$ | 19,4 | - | 38 | 11,8 | 180-200 |

RM 1 = "(R)Resin M" mit einer mittleren Molekularmasse von 4 500
RM 2 = " " " " " 10 000

Beispiele 19 bis 27

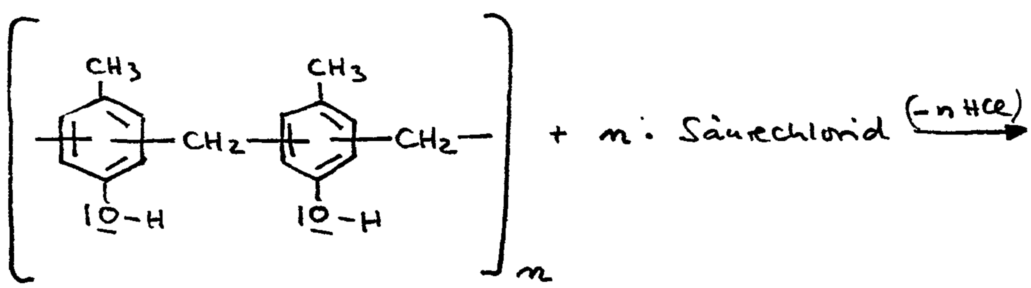


"(R)Alnovol PN 429" der
HOECHST AG = "A"

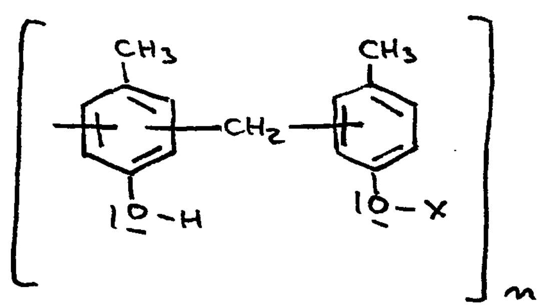

H O E C H S T   A K T I E N G E S E L L S C H A F T
KALLE  Niederlassung der Hoechst AG



Tabelle II

| | Edukte | | | | Produkte | | | |
|---|---|---|---|---|---|---|---|---|
| Beispiel | Phenolharz | Gew.-Teile | Säurechlorid | Gew.-Teile | $F_1$ (Gew.-Teile) | $F_2$ (Gew.-Teile) | % F | Tm (°C) |
| 19 | A | 24,6 | $C_{7,5}F_{16}CH_2OCO$<br>CH<br>‖<br>CH<br>Cl-CO | 43,8 | 9,5 | 53,9 | 40,0 | 80- 90 |
| 20 | A | 24,6 | | 33,2 | 6,1 | 47,4 | 35,4 | 100-120 |
| 21 | A | 24,6 | | 16,6 | - | 38,8 | 22,5 | 130-150 |
| 22 | A | 24,6 | $C_8F_{17}CH_2COCl$ | 32,8 | 3,1 | 56,6 | 37,9 | 110-130 |
| 23 | A | 24,6 | " | 24,9 | 2,0 | 42,0 | 34,1 | 120-140 |
| 24 | A | 24,6 | " | 12,5 | - | 34,6 | 22,5 | 130-150 |
| 25 | A | 9,8 | 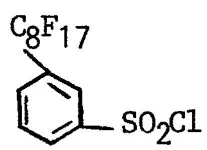 | 5,94 | - | 15,6 | 19,4 | 140-160 |
| 26 | A | 24,6 | $C_7F_{15}COCl$ | 21,6 | 3,3 | 34,4 | 27,9 | - |
| 27 | A | 12,3 | $CH_3$<br>Cl-CH-COOCH$_2$ *)<br>$C_6F_{13}$-CH$_2$ | 11,8 | - | 18 | - | - |

*) hergestellt aus Chlorpropionsäurechlorid und $C_6F_{13}C_2H_4OH$ in Gegenwart von Triethylamin; außerdem wird anstelle von Triethylamin bei der weiteren Umsetzung $K_2CO_3$ eingesetzt

HOECHST AKTIENGESELLSCHAFT
KALLE Niederlassung der Hoechst AG



Beispiel 28 (Anwendungsbeispiel)

Die erfindungsgemäßen Polymeren der Beispiele 3 bis 27 und 15 bis 18 werden jeweils in Butanon-2 bzw. einem Gemisch aus Butanon-2 und 1-Methoxy-propanol-2 gelöst und auf eine aufgerauhte Aluminiumfolie aufgeschleudert, währen 1 bis 2 min mit einem Gebläse getrocknet und dann während 1 min bei 100 °C im Trockenschrank getrocknet. Die Platten werden mit einer im Handel erhältlichen Druckfarbe für den wasserlosen Offsetdruck eingewalzt und zeigen eine sehr gute bis gute Farbabstoßung, sie waren praktisch tonfrei (Polymere der Beispiele 5, 12, 15 und 16) bzw. zeigten sehr wenig Ton (Polymere der Beispiele 3, 4, 6 bis 10, 13, 14 und 19 bis 25). Bei sich anschließenden Druckversuchen, in denen von beschichteten Aluminiumteststücken neben unbeschichteten auf einer Druckmaschine bei abgeschaltetem Feuchtwerk gedruckt wurde, ergaben sich vergleichbare Ergebnisse.

Beispiele 29 bis 45 (Anwendungsbeispiele)

Die in den Beispielen 3 bis 27 synthetisierten Produkte können als organisches polymeres Bindemittel im Gemisch mit einer Perfluoralkylgruppen aufweisenden 1,2-Naphthochinon-diazidverbindung und einem Farbstoff zu einer Reproduktionsschicht verarbeitet werden. Dazu wird im Regelfall eine Lösung oder Dispersion der Komponenten in einem organischen Lösemittel (Butanon-2, 1-Methoxy-Propanol-2, THF oder Ethylenglykolmonomethylether (MG)) hergestellt und auf ein Trägermaterial wie eine elektrochemisch aufgerauhte Aluminiumfolie oder eine Polyesterfolie aufgebracht. Anschließend wird die strahlungsempfindliche Beschichtung getrocknet.

Die so vorbereiteten Offsetdruckplatten werden mit einer Metallhalogenidlampe (5 kW) im Abstand von 100 cm zwischen Lampe und Vakuumkopierrahmen durch eine Negativvorlage hindurch während 20 bis 150 sec belichtet. Die Entwicklung des belichteten Materials kann mit einer wäßrigen $Na_2SiO_3$-Lösung (E1) durchgeführt werden. Nach Abwaschen mit Wasser und einer kurzen Trocknung bei 100 °C kann mit den so hergestellten Druckformen trocken (d. h. unter Abschalten des Feuchtwerks einer Druckmaschine) mit käuflichen Spezialfarben für dem wasserlosen Offsetdruck gedruckt werden. Die farbannehmenden Stellen sind Teile der Oberfläche des Trägermaterials, die farbabstoßenden Stellen die stehengebliebenen Teile der Reproduktionsschicht.

Als strahlungsempfindliche Verbindung werden V1 = Umsetzungsprodukt von 1 Mol 2,3,4-Trihydroxy-benzophenon mit 1 Mol $C_{7,5}F_{16}CH_2CHOOC$ - CH = CH COCl (Buten-2-di-1,4-säure-monochlorid-monofluoralkylethylester) und 2 Mol 1,2-Naphthochinon-2-diazid-5-sulfonsäurechlorid und V2 = Umsetzungsprodukt von 1 Mol 1-Perfluoroctanoyloxy-2,4-dihydroxybenzol mit 2 Mol des Chinondiazids eingesetzt.

Als Beurteilungskriterien für die Reproduktionsschicht dienen die Beschichtungsqualität (G = gut, B = befriedigend, M = mäßig, S = schlecht) durch visuelle Beurteilung vor der Bestrahlung, Entwicklung und Einfärbung und nach diesen Verfahrensstufen die Anzahl der freien bzw. gedeckten Stufen in einem Halbtonstufenkeil mit 13 Stufen einer Keilkonstante (Dichteabstufung) von 0,15

(z. B. Belichtungstestkeil "BK01" der Firma KALLE Niederlassung der Hoechst AG) und die Wiedergabe von feinsten Bildelementen in einem 12stufigen Rasterkeil mit 60er Raster, beginnend mit einem Tonwert von 5 % in Stufe 1 und endend mit einem Tonwert von 95 % in Stufe 12 (z. B. Rasterkeil "RK01" der Firma KALLE Niederlassung der Hoechst AG); bei der Anwendung des Rasterkeils sind einerseits in der Tabelle die Anzahl der Felder angegeben, die noch Farbe abstoßen (v) (d. h. Nichtbildstellen aufweisen) und andererseits das Feld, das erstmals Farbe annimmt (w).

Tabelle III

| Komponenten, Behandlungsmittel, Beurteilung | | Gew.-Teile der Komponenten (bzw. andere Parameter) im Beispiel | | | |
|---|---|---|---|---|---|
| | | 29 | 30 | 31 | 32 |
| Chinondiazid | V1 | 1,4 | 1,4 | 1,4 | 1,4 |
| | V2 | - | - | - | - |
| Als Bindemittel Polymeres des | Bsp.4 | | | | |
| | 6 | 0,8 | | | |
| | 7 | | 0,8 | | |
| | 8 | | | | |
| | 9 | | | 0,8 | |
| | 10 | | | | 0,8 |
| | 12 | | | | |
| | 13 | | | | |
| | 14 | | | | |
| | 15 | | | | |
| | 16 | | | | |
| | 20 | | | | |
| | 21 | | | | |
| | 22 | | | | |
| | 23 | | | | |
| | 24 | | | | |
| | 26 | | | | |
| Farbstoff | | 0,02 | 0,02 | 0,02 | 0,02 |
| THF | | 5 | 5 | 5 | 5 |
| Butanon-2 | | 15 | 15 | 15 | 15 |
| 1-Methoxy-propanol-2 | | - | - | - | - |
| MG | | 4 | 4 | 4 | 4 |
| Beschichtungsqualität | | – | – | – | – |
| Belichtungszeit (sec) | | 100 | 100 | 100 | 100 |
| Entwickler | | E1 | E1 | E1 | E1 |
| Entwicklungszeit (min) | | 5 | 5 | 2 | 5 |
| Halbtonstufenkeil (x/y) *) | | 11/8 | 12/10 | 10/7 | 10/9 |
| Rasterkeil (v/w) | | 1/12 | 4/12 | 7/12 | 1/12 |

*) x = Anzahl der vollgedeckten Stufen
y = Summe von vollgedeckten und teilgedeckten Stufen

H O E C H S T   A K T I E N G E S E L L S C H A F T
KALLE  Niederlassung der Hoechst AG



Tabelle III

| Komponenten, Behandlungsmittel, Beurteilung | | Gew.-Teile der Komponenten (bzw. andere Parameter) im Beispiel | | | |
|---|---|---|---|---|---|
| | | 33 | 34 | 35 | 36 |
| Chinondiazid | V1 | 1,4 | 1,4 | 1,4 | 1,4 |
| | V2 | - | - | - | - |
| Als Bindemittel | Bsp.4 | | | | |
| Polymeres des | 6 | | | | |
| | 7 | | | | |
| | 8 | | | | |
| | 9 | | | | |
| | 10 | | | | |
| | 12 | 0,8 | | | |
| | 13 | | 0,8 | | |
| | 14 | | | | |
| | 15 | | | 0,8 | |
| | 16 | | | | 0,8 |
| | 20 | | | | |
| | 21 | | | | |
| | 22 | | | | |
| | 23 | | | | |
| | 24 | | | | |
| | 26 | | | | |
| Farbstoff | | 0,02 | 0,02 | 0,02 | 0,02 |
| THF | | 5 | 5 | 5 | 5 |
| Butanon-2 | | 15 | 15 | 15 | 15 |
| 1-Methoxy-propanol-2 | | - | - | - | - |
| MG | | 4 | 4 | 4 | 4 |
| Beschichtungsqualität | | — | — | — | — |
| Belichtungszeit (sec) | | 100 | 100 | 100 | 100 |
| Entwickler | | E1 | E1 | E1 | E1 |
| Entwicklungszeit (min) | | 1,5 | 1,5 | 1,5 | 1,5 |
| Halbtonstufenkeil (x/y) | | 9/6 | 9/7 | 9/6 | 9/6 |
| Rasterkeil (v/w) | | 1/12 | 2/12 | 1/12 | 4/12 |

H O E C H S T   A K T I E N G E S E L L S C H A F T
KALLE  Niederlassung der Hoechst AG

Tabelle III



| Komponenten, Behandlungsmittel, Beurteilung | | Gew.-Teile der Komponenten (bzw. andere Parameter) im Beispiel | | | |
|---|---|---|---|---|---|
| | | 37 | 38 | 39 | 40 |
| Chinondiazid | V1 | 1,4 | 1,4 | 1,4 | 1,0 |
| | V2 | - | - | - | 0,5 |
| Als Bindemittel | Bsp.4 | | | | 1,0 |
| Polymeres des | 6 | | | | |
| | 7 | | | | |
| | 8 | | | | |
| | 9 | | | | |
| | 10 | | | | |
| | 12 | | | | |
| | 13 | | | | |
| | 14 | | | | |
| | 15 | | | | |
| | 16 | | | | |
| | 20 | | | | |
| | 21 | 0,8 | | | |
| | 22 | | 0,8 | | |
| | 23 | | | 0,8 | |
| | 24 | | | | |
| | 26 | | | | |
| Farbstoff | | 0,02 | 0,02 | 0,02 | 0,02 |
| THF | | 5 | 5 | 5 | - |
| Butanon-2 | | 15 | 15 | 15 | 19 |
| 1-Methoxy-propanol-2 | | - | - | - | 5 |
| MG | | 4 | 4 | 4 | - |
| Beschichtungsqualität | | - | - | - | M |
| Belichtungszeit (sec) | | 100 | 100 | 100 | 100 |
| Entwickler | | E1 | E1 | E1 | E1 |
| Entwicklungszeit (min) | | 5 | 3 | 1 | 1,5 |
| Halbtonstufenkeil (x/y) | | 9/7 | 9/7 | 9/6 | 7/- |
| Rasterkeil (v/w) | | 2/12 | 2/12 | 2/12 | 2/12 |

HOECHST AKTIENGESELLSCHAFT
KALLE Niederlassung der Hoechst AG

Tabelle III



| Komponenten, Behandlungsmittel, Beurteilung | | Gew.-Teile der Komponenten (bzw. andere Parameter) im Beispiel | | | | |
|---|---|---|---|---|---|---|
| | | 41 | 42 | 43 | 44 | 45 |
| Chinondiazid | V1 | 1,0 | 1,0 | 1,0 | 1,0 | 1,0 |
| | V2 | | | | | |
| Als Bindemittel Polymeres des | Bsp.4 | | | | | |
| | 6 | | | | | |
| | 7 | | | | | |
| | 8 | 0,5 | | | | |
| | 9 | | | | | |
| | 10 | | | | | |
| | 12 | | | | | |
| | 13 | | | | | |
| | 14 | | 0,5 | 0,5 | 0,5 | |
| | 15 | | | 0,5 | | |
| | 16 | | | | | |
| | 20 | 0,5 | 0,5 | | | |
| | 21 | | | | | |
| | 22 | | | | | |
| | 23 | | | | | |
| | 24 | | | | 0,5 | |
| | 26 | | | | | 1,0 |
| Farbstoff | | 0,02 | 0,02 | 0,02 | 0,02 | 0,2 |
| THF | | - | - | - | - | - |
| Butanon-2 | | 19 | 19 | 19 | 19 | 19 |
| 1-Methoxy-propanol-2 | | 5 | 5 | 5 | 5 | 5 |
| MG | | - | - | - | - | - |
| Beschichtungsqualität | | G | M | G | G | M |
| Belichtungszeit (sec) | | 100 | 100 | 100 | 100 | 100 |
| Entwickler | | E1 | E1 | E1 | E1 | E1 |
| Entwicklungszeit (min) | | 1 | 1,5 | 3 | 1 | 0,5 |
| Halbtonstufenkeil (x/y) | | 11/8 | 8/7 | 11/9 | 8/6 | 6/- |
| Rasterkeil (v/w) | | 2/12 | 1/12 | 3/12 | 1/12 | 2/12 |

H O E C H S T   A K T I E N G E S E L L S C H A F T
KALLE Niederlassung der Hoechst AG

84/K050  28. Mai 1985
WLK-Dr.N.-ur

## Patentansprüche

1. Perfluoralkylgruppen enthaltende Polymere, dadurch gekennzeichnet, daß sie - jeweils als Substituenten an unterschiedlichen C-Atomen von Benzolringen - phenolische OH-Gruppen und gegebenenfalls über Zwischenglieder gebundene Perfluoralkylgruppen aufweisen.

2. Polymere nach Anspruch 1, dadurch gekennzeichnet, daß sie Polymerbausteine enthalten, die durch die allgemeinen Formeln (Ia) oder (IIa) charakterisiert sind

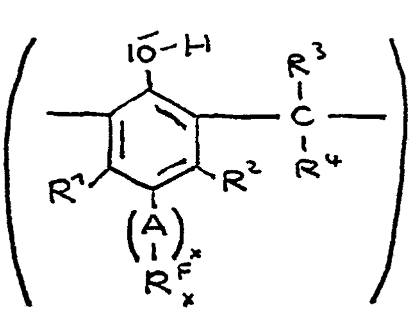

(Ia)

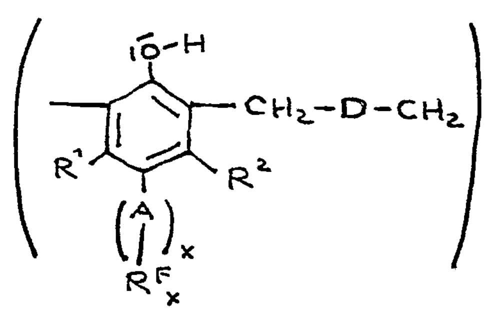

(IIa)

und in denen $R^1$, $R^2$ = H, Alkyl von $C_1$ bis $C_6$, $R^F$, $\overline{O}$-H, $\overline{O}$ - Alkyl($C_1$ bis $C_6$), $\overset{|O|}{\overset{\|}{C}}-R^F$; $R^F = F(C_wF_{2w})(-CH_2)_z$ oder $F(C_{w-1}F_{2w-2})-CF = CH$, wobei die Difluormethylengruppen gegebenenfalls auch über Etherbrücken verknüpft sein können; w = 5 bis 15; z = 0 bis 5; x = 0 oder 1; $R^3$, $R^4$ = Alkyl von $C_1$ bis $C_6$, H, Phenyl, $R^F$, $A = \overset{|O|}{\overset{\|}{C}} - \overline{O}$, $R^F$, $\overset{|O|}{\overset{\|}{C}} - R^F$, $\overset{|O|}{\overset{\|}{C}} - \overline{O} - H$; D = Alkylen von $C_1$

bis $C_8$, Phenylen, Naphthylen, Biphenylen (auch mit Ether-, Thioether- oder Carbonylgruppen überbrückt) bedeuten.

3. Polymere nach Anspruch 1, dadurch gekennzeichnet, daß sie Polymerbausteine enthalten, die durch die allgemeinen Formeln (IIIa) bis (VIa) charakterisiert sind

(IIIa) 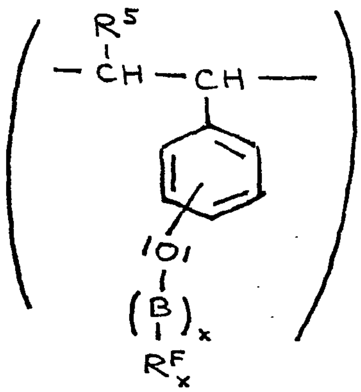

(IVa) 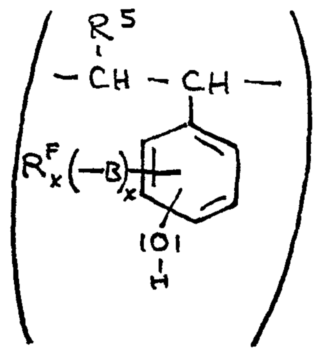

(Va) 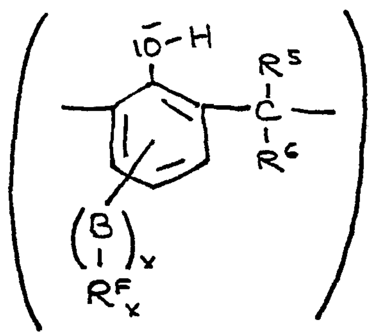

(VIa) 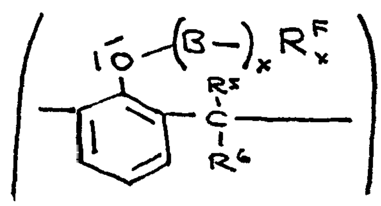

und in denen $R^5$, $R^6$ = H, Alkyl von $C_1$ bis $C_6$, Phenyl, Naphthyl; B = $\overset{|\overline{O}|}{\overset{\|}{C}}$, $\overset{|\overline{O}|}{\overset{\|}{C}} - (CH_2)_z - \underline{\overline{O}}$, $\overset{R^7}{\overset{|}{C}H} - \underline{\overline{O}}$ ($R^7$ = Alkyl von $C_1$ bis $C_{12}$), $\overset{|\overline{O}|}{\overset{\|}{C}} - (CH_2)_z - \overset{|\overline{O}|}{\overset{\|}{C}} - \underline{\overline{O}}$, $SO_2$, $SO_2$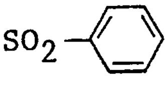 bedeuten.

4. Polymere nach Anspruch 2, dadurch gekennzeichnet, daß 10 bis 100 % der Polymerbausteine Perfluoralkylgruppen tragen.

5. Polymere nach Anspruch 3, dadurch gekennzeichnet, daß 10 bis 90 % der Polymerbausteine Perfluoralkylgruppen tragen.

6. Verfahren zur Herstellung der Polymeren nach Anspruch 2 oder 4, dadurch gekennzeichnet, daß ein substituiertes Phenol mit einem Aldehyd, Keton oder einer reaktiven Bismethylenverbindung kondensiert wird.

7. Verfahren zur Herstellung der Polymeren nach Anspruch 3 oder 5, dadurch gekennzeichnet, daß ein phenolische OH-Gruppen aufweisendes Polymerisat oder Polykondensat mit einer Perfluoralkylgruppen aufweisenden Verbindung umgesetzt wird.

8. Strahlungsempfindliche Reproduktionsschicht mit einem Gehalt an (c) mindestens einer strahlungsempfindlichen Verbindung und (d) mindestens einem organischen polymeren Bindemittel, dadurch gekennzeichnet, daß die Komponente (d) ein Polymeres gemäß einem der Ansprüche 1 bis 5 ist.

9. Reproduktionsschicht nach Anspruch 8, dadurch gekennzeichnet, daß das Polymere in wäßrig-alkalischen Lösungen löslich ist.

HOECHST AKTIENGESELLSCHAFT
KALLE Niederlassung der Hoechst AG



10. Reproduktionsschicht nach Anspruch 8 oder 9, dadurch gekennzeichnet, daß die Komponente (c) mindestens eine Verbindung enthält, die mindestens eine Perfluoralkylgruppe aufweist.

11. Reproduktionsschicht nach einem der Ansprüche 8 bis 10, dadurch gekennzeichnet, daß die Komponente (c) mindestens eine polymerisierbare, Perfluoralkylgruppen aufweisende Verbindung mit mindestens zwei endständigen ethylenisch-ungesättigten Gruppen und mindestens einen Photoinitiator enthält.

12. Reproduktionsschicht nach einem der Ansprüche 8 bis 10, dadurch gekennzeichnet, daß die Komponente (c) mindestens eine 1,2-Naphthochinondiazidverbindung enthält, die als Substituenten mindestens eine Perfluoralkylgruppe aufweist.

13. Verwendung einer Reproduktionsschicht nach den Ansprüchen 8 bis 12 als strahlungsempfindliche Beschichtung von Druckplattenträgermaterialien für den wasserlosen Offsetdruck.

-.-.-